# EUROPEAN PATENT APPLICATION

(11) **EP 1 466 723 A1**
(43) Date of publication of application: **13.10.2004**
(21) Application number: 02790761.7
(22) Date of filing: 13.12.2002
(51) Int. Cl.: B32B 27/06

(54) **COMPOSITE RESIN MOLDING AND PROCESS FOR PRODUCING THE SAME**

(30) Priority: 17.12.2001 JP 2001383118
(71) Applicant: Suzuka Fuji Xerox Co., Ltd., Suzuka-shi, Mie 519-0393 (JP)
(72) Inventor: SUZUKI, Yasuhiro, Suzuka-shi, Mie 519-0393 (JP)
(74) Representative: VOSSIUS & PARTNER
(86) International application number: PCT/JP2002/013105
(87) International publication number: WO 2003/051628

(57) **Abstract**

The object of the present invention is to provide a compound resin mold consisting of solvent soluble and insoluble thermoplastic resin elements and a method for the manufacturing thereof.

For example, in a case where said compound resin mold is a printed circuit board, the base board consists of said soluble thermoplastic resin element, with said insoluble elements being the metal thin film circuit and thermosetting resin film formed on said base board.

## Description

### Field of the invention

The present invention relates to a compound resin mold consisting of thermoplastic resin elements being solvent soluble and insoluble, and a recycling method therefor.

### Background of the invention

In the printed circuit boards being used as the electronic parts of various electric appliances and the like, thermosetting resin(s) such as epoxy resin, phenolic resin, melamine resin and the like, to which glass fiber, cellulose fiber, inorganic filler, and the like is(are) added, is(are) used as main material(s).

Said thermosetting resin can not be heat-melted, and is solvent insoluble. Therefore, the recycling of said thermosetting resin mold such as said printed circuit board and the like has been difficult. In particular, the thin metal film circuit and thermosetting resin film are formed on the surface of said printed circuit board, and glass fiber, cellulose fiber, inorganic filler and the like is(are) contained in said board as described above, making the recycling of said printed circuit board more difficult. Further, heavy metal(s) such as lead, tin and the like is(are) contained in said board, and still further, in a case where said board is made of an epoxy resin as thermosetting resin, bisphenol A, which is a component of said epoxy resin, acts as an environmental hormone, so that extreme care is necessary even after the disposing of such a board in the ground.

Generally, a halogenide fire retardant such as a bromide fire retardant, chloride fire retardant and the like are used to give fire retardancy to the resin(s) of which said printed circuit board is composed, and in the case of incineration or thermal recycling of said discarded board, it is feared to cause a problem such as generation of dioxine and the like.

### Disclosure of the invention

To solve above described problems, the present invention provide a compound resin mold consisting of thermoplastic resin element(s) being solvent soluble and having a heat distortion point higher than 80°C, said point being measured by the method following ASTM D648, applying a load of 1,820 MPa, and solvent insoluble element(s).

For example, said compound resin mold is a printed circuit board and, said board is made of said thermoplastic resin element being solvent soluble, and said solvent insoluble elements are thin metal film circuit and thermosetting resin film, formed on said board.

It is desirable that a fire retardant containing no halogen element is added to said solvent soluble thermoplastic resin element.

Further, the present invention also provides a method for manufacturing a recycled compound resin mold comprising dissolving discarded compound resin molds in solvent to separate solvent insoluble element(s), recovering said thermoplastic resin element(s) dissolved in said solvent by evaporating said solvent, and recycling said recovered thermoplastic resin as resin mold material. In said method for manufacturing a recycled compound resin mold, it is desirable that recycle aid agent(s) is (are) added to said recycled thermoplastic resin recovered by evaporating said solvent in which said thermoplastic resin is dissolved, and it is desirable that said recycle aid agent(s) is(are) virgin thermoplastic resin and/or virgin thermoplastic resin having compatibility with said recycled thermoplastic resin and/or rubber-like material and/or inorganic reinforcing material and/or organic reinforcing material.

Since said compound resin mold consists of thermoplastic resin elements) (soluble thermoplastic resin element) being solvent soluble and having a heat distortion point higher than 80°C, said point being measured by the method following ASTM D648 and applying a load of 1,820MPa, and element being solvent insoluble (insoluble element), said soluble thermoplastic resin element(s) has(have) enough mechanical strength(s) to be used for the printed circuit board, and when discarded, compound resin mold is recycled, said soluble thermoplastic resin element(s) and said insoluble element(s) are simply separated by dissolving said discarded compound resin mold in solvent, since said insoluble element(s) do not dissolve therein. Said separated thermoplastic resin(s) is (are) recycled as resin mold material(s), the usable insoluble element(s) being separated and recovered by the proper method.

### Preferred embodiment

The present invention is detailed below.

### [Soluble thermoplastic resin]

The thermoplastic resins used in said compound resin mold of said printed circuit board and the like of the present invention is e.g. styrene group resin, vinyl acetate group resin, methacryl group resin, vinyl group resin, amino group resin, olefin group resin, ester group resin, ether group resin and the like, such as ethylene-vinyl acetate resin, polystyrene, high impact polystyrene(HIPS), styrene-acrylonitrile resin, styrene-acrylontrile-butadiene resin(ABS), polyvinyl acetate, polymethyl methacrylate, thermoplastic polyester, thermoplastic polyamide and the like.

In particular, in a case where said compound resin mold is a printed circuit board, it is desirable that soluble thermoplastic resin having a heat distortion point higher than 80°C, said point being measured by the method following ASTM D648, is used, and said thermoplastic resin is e.g. polycarbonate(PC), polyetherimide(PEI), polyamideimide(PAI), polysulfone(PSF), polyamide(PA), polyethylene terephthalate(PET), polybutylene telephtalate(PBT), polyethylene naphthalate(PEN), polyarylate(PAR), polyphemylane ether(PPE), modified polyphenylene ether(m-PPE) and the like.

Further, the thermoplastic resin used in the present invention is a styrene group thermoplastic elastomer such as styrene-butadiene block copolymer (SBS), styrene-isoprene-styrene block copolymer(SIS), styrene-ethylene-butylene-styrene block copolymer(SEBS), styrene-ethylene-propylene-styrene block copolymer(SEPS) and the like. Said thermoplastic elastomer is used as the main material of said resin mold, and further, said thermoplastic elastomer may be mixed with other thermoplastic resins as described above, or said thermoplastic elastomer may be used as a material for the attachment to said resin mold.

Further, since said thermoplastic resin used in the present invention is dissolved in solvent when said thermoplastic resin is recycled, it is desirable that said themoplastic resin is chemically stable for solvent.

### [Insoluble element]

The insoluble element used in the present invention is one such as a metal, ceramic, wood material, thermosetting resin, filler and the like, which are attached to said soluble thermoplastic resin element. For example, in the case of a printed circuit board, said insoluble element is such as thin metal film circuit formed on the surface of said thermoplastic resin board, said metal being Cu, solder used for the connection of said circuit, said solder including thermosetting resin, ultraviolet cure type resin and the like in which electroconducting filler such as metal powder and the like is dispersed, glass fiber and cellulose fiber mixed in said board, and inorganic filler. Further, in the case of the electromagnetic interference shield resin mold, said insoluble element is e.g. metal powder, said metal being e.g. silver, copper, nickel, cobalt, iron, aluminum, and the like, carbon powder, and the like which are mixed in said resin mold, carbon and said metal powder contained in the paint film on the surface of said resin mold, thermosetting resin in the paint and the like. Further, in a general resin mold, inorganic filler, organic filler and inorganic pigment are commonly, added as insoluble elements. Said inorganic filler is e.g. a glass fiber, glass bead, carbon fiber, ceramic fiber, metal fiber, mica, talc, calcium carbonate, aluminum silicate, kaolin, silica, calcium metasilicate, bituminous material fine powder, zeolite, diatomaceous earth, silica sand, pumice powder, slate powder alumina, iron oxide, aluminum sulfate, barium sulfate, lithopone, calcium sulfate, magnesium oxide, molybdenum disulfide, and the like, and organic filler is e.g. a rubber powder, ebonite powder, shellac, wood powder, coconut powder, cork powder, cellulose powder, wood pulp, paper, cloth, silicone resin fine powder, and the like, and further, inorganic filler is e.g. a mica powder, graphite, glass ball(GB), volcanic glass balloon, carbon balloon, anthracite powder, artificial crystal stone, silica spherical fine powder and the like, and said inorganic pigment is e.g. a titanium oxide, carbon black, Indian red, chrome yellow and the like.

Furthermore, said insoluble element includes the thermosetting resin used to connect each respective resin mold, and to connect a resin mold with non-resin parts, and thermosetting resin and inorganic pigment contained in the paint used for the coating of a resin mold.

Said thermosetting resin is e.g. a melamine resin, alcohol modified melamine resin, phenolic resin, urea resin, resorcinol resin, benzoguanamine resin, epoxy resin, thermosetting urethane resin, thermosetting acrylic resin, melamine-alkyd resin and the like, and said pigment is e.g. a titanium oxide, carbon black, Indian red, chrome yellow and the like. Further, a resist film is formed by coating on the surface of said printed circuit board, or print with the printing ink is applied on the surface of said printed circuit board. The resin used in coating agent for resist, paint or ink is e.g. shellac, rosin, ester gum, hardened rosin, decolorized shellac, alkyd resin, rosin modified alkyd resin, phenol modified alkyd resin, epoxy modified alkyd resin, styrenated alkyd resin, acrylated alkyd resin, urethane modified alkyd resin, silicon modified alkyd resin, amino modified alkyd resin, phthalic resin, amino resin, melamine resin, butyl melamine resin, methyl melamine resin, benzoguanamine resin, amino alkyd copolycondensation polymer, urea resin, epoxy resin such as glycidyl ether type (bisphenol A type, bisphenol F type, 2,6-xylenol type, brominated bisphenol A type, phenol novolak type, o-cresol novolak type), glycidyl ester type, glycidyl amine type (aromatic amine), alicyclic type and the like, polyurethane resin; one-component polyurethane resin such as oil modified polyurethane resin, moisture hardening type polyurethane resin, heat cross linking type polyurethane(block isocyanate), lacquer type polyurethane and the like; catalyst hardened polyurethane resin; two-component polyurethane resin, such as polyol setting type polyurethane, acryl polyol, polyester polyol, polyetherpolyol, epoxy polyol, isocyanate, polyol and the like; unsaturated polyester resin, phenol resin, NAD resin, emulsion type resin such as acryl resin emulsion, styrene acryl resin emulsion, epoxy resin emulsion, urethane resin emulsion, acryl silicon resin emulsion, fluororesin emulsion; water soluble resin such as water soluble alkyd resin, water soluble acrylated alkyd resin, water soluble polyester resin, water soluble acryl resin, water soluble epoxy ester resin, water soluble melamine resin; chlorinated polyolefin resin (e.g. chlorinated PE, chlorinated PP and the like), chlorinated rubber, silicone resin; modified resin such as alkyd resin, epoxy resin, polyester resin, acryl resin, urethane resin, fluororesin, xylene resin, phenol-xylene resin, oil petroleum resin, ketone resin, rosin modified maleic resin, cumarone resin, ethyl silicate, ultraviolet curing resin (e.g. unsaturated polyester, urethane acrylate, epoxy acrylate, ester acrylate), vinyl chloride, vinyl acetate, vinyl acetate-vinyl propionate resin, vinylidene chloride, maleic acid, polyvinyl alcohol, polyvinyl butyral (including those usable as a thermosetting resin since these cross-link with a functional group of epoxy resin, phenol resin, melamine resin, urea resin and isocyanate), acrylic resin such as thermoplastic acrylic resin, thermosetting acrylic resin, epoxy setting acrylic resin, melamine modified resin, acrylpolyol for cross-linking agent of block isocyanate, modified acrylic resin, vinyl acetate modified resin, styrene modified resin, vinyl toluene acryl silicone resin, polyamide and the like.

Only the solvent insoluble resin described above is usable in the present invention, and said resin is cured by using isocyanate for cross-linking, said thermoplastic resin becoming insoluble.

### [Fire retardant]

For example, in said printed circuit board, a fire retardant is added to prevent any ignition due to overheated drums.

Up to now, a fire retardant containing chlorine or bromine has been used but said fire retardant containing halogen, on incineration, remarkably contaminates the atmosphere. Accordingly, a non-halogen type fire retardant is desirable for use in said compound resin mold of the present invention. Said non halogen fire retardant is e.g. diantimony trioxide, antimony type fire retardant, diantimony pentaoxide, sodium antimonite, magnesium hydroxide, aluminum hydroxide, zinc borate, guanidine type fire retardant, guanidine sulfamate, guanidine phosphate, guanyl urea phosphate, zirconium type fire retardant, tin compound, molybdenum compound, red phosphorus, guanidine type fire retardant, silicon type fire retardant, phosphate type fire retardant such as phosphate, phosphorous compound, tris allyl phosphate, tris(3-hydroxypropyl) phosphine oxide, tris(tribromoneopentyl) phosphate, dimethyl methyl phosphate, aromatic condensed phosphate, ethylene • bis • tris(2-cyanoethyl) phosphorus bromide, ammonium polyphosphate, butyl pyrophosphate, butyl acid phosphate, butoxy ethyl acid phosphate, 2-ethylhexyl acid phosphate, melamine phosphate; fire retardant on the market such as fire retardants made by Sandoz Ltd., such as Sand flam 5060 which is organic phosphate fire retardant, fire retardants made by Nippon Chemical Industrial Co., Ltd. such as Hishiguard RP, Hishiguard CP, Hishiguard Safe PM-24, Hishiguard Safe PM-24I, Hishiguard Safe PM-34, Hishiguard Safe PM-34I, Hishiguard Safe PM-13, Hishiguard EP-15, Hishiguard UR-15, fire retardants made by RINKAGAKU KOUGYO CO., LTD. such as NOVA RED #120, NOVA RED #280, NOVA QUELL ST-100, NOVA QUELL ST-200, NOVAQUELL W-100, fire retardants made by Albright & Willson such as AMGARD CRP, AMGARD CRPA, AMGARD MC, AMGARD PI, fire retardants made by Hoechst such as NG, NN, NF, NFF which are stabilization type fire retardants, SG, SN, SF, SFF which are unstabilization type fire retardants, reactive fire retardants such as chlorendic anhydride, diethoxy-bis-(2-hydroxyethyl)-aminomethyl • phosphate, phenyl phosphonic acid, phenyl phosphonic acid dichloride, diethylphenyl phosphonate, dimethyl phenyl phosphonate, diallyl chlorendate, reactive noncombustible polyol, dibutylbis(2-hydroxypropyl)pyrophosphate, noncombustible stabilizers made by ASAHI DENKA CO., LTD. such as ADECA SIZER ER-13, ADECA STAB ZS-66, ADECA STAB ZS-506 which are epoxy type stabilizers, stabilizers for ABS type polymer blend such as butyl • tin • malate type, octyl • tin • malate type, butyl • tin • sulfur type, stabilizers made by SANKYO YUKI GOSEI, such as Stan BM(N), Stan OMF, JF-9B, Stan JF-95B, Stan BK-1100L, Stan JF-95B, Stan BK-1100L, Stan ONZ-20, Stan ONZ-22, Stan ONZ-22P and the like, stabilizers made by Kyowa Chemical Industry Co., Ltd. such as DHT-4A-2 and the like, silicon resin, silicon oil, fluororesin, fluoro type oil, noncombustible stabilizers made by ADECA ARGUS such as Mark EP-13, EP-17, EP-22, Mark273 which are epoxy type stabilizers, other noncombustible stabilizers made by ADECA ARGUS such as Mark-ZS-66, ZS-506, stabilizers for ABS-PVC type polymer blend made by SANKYO YUKI GOSEI, such as StanMMS, MC and the like.

### [ Solvent]

A discarded compound resin mold of the present invention is dissolved in solvent when it is to be recycled. Said solvent used for dissolving said discarded compound resin mold, in other words, the thermoplastic resin of said resin mold, is e.g. n-heptane, n-hexane, gasoline for industrial use, kerosene, toluene, xylene, benzene, trimethylbenzene, tetralin, dipentene, turpentine, cyclohexane, methylcyclohexane, ethylcyclohexane, styrene and the like; alcohol such as methanol, ethanol, modified alcohol, n-propanol, iso-propanol, n-butanol, iso-butanol, sec-butanol, tert-butanol, n-amyl alcohol, iso-amyl alcohol, 2-ethylhexanol, methylisobutylcarbinol, benzyl alcohol, furfuryl alcohol, ether alcohol, ether; methyl cellosolve, butyl cellosolve, isobutyl cellosolve, tert-butyl cellosolve, isopropyl cellosolve, hexyl cellosolve, methoxy butanol, 3-methyl-3-methoxybutanol, carbitol, methyl carbitol, butyl carbitol, propylene glycol mono methyl ether, dipropylene glycol mono methyl ether, dioxane and the like; ester, ether, methyl acetate, ethyl acetate, n-propyl acetate, isopropyl acetate, isobutyl acetate, iso amyl acetate, methyl cellosolve acetate, cellosolve acetate, butyl cellosolve acetate, methoxy propyl acetate, methoxy butyl acetate, carbitol acetate, butyl carbitol acetate, 3-methyl 3-methoxybutanol acetate, 3-ethoxyethanol propionate, ketone, acetone, methyl ethyl ketone, methyl isobutyl ketone, diisobutyl ketone, methyl hexyl ketone, methyl amyl ketone, cyclohexanone(anone), diacetone alcohol, isophorone, methylene dichloride, ethylene tetrachloride, 1,1,1-trichloroethane, o-dichlorobenzene, CFC, HCFC, tetrahydrofuran, 2-nitro propane, N,N-dimethylformamide and the like. Said solvent is used singly or a mixture of two or more solvents is used.

Said solvent used in the present invention should have a high solubility for said thermoplastic resin, and chemical stability for said thermoplastic resin, and further, said solvent desirably has a low toxicity and a low boiling point(such as lower than 150°C). In the present invention, said solvent is selected considering said requirements for thermoplastic resin to be dissolved.

### [Dissolving process]

Said discarded compound resin mold made of said soluble thermoplastic resin is dissolved in solvent as it is or after said discarded resin mold has been crushed. To promote the solubility of said discarded resin mold in said solvent, said solvent or solution may be stirred and/or heated to a degree, meaning that said stirring and/or heating does not damage the properties of said recycled thermoplastic resin. An airtight tank is desirable for the dissolving process, and if necessary, said dissolving is carried out in an inert atmosphere such as a nitrogen gas atmosphere, and further, said tank may also be vibrated, as opposed to stirred.

### [Insoluble element removing process]

Said discarded resin mold dissolved in solvent in the above described dissolving process is separated into a soluble thermoplastic resin element and an insoluble element.

For this separation, for example, a centrifuge and/or filtration process is applicable.

### [Resin recovering process]

Said insoluble element(s) is(are) removed from said solution in said insoluble element removing process and said solvent is removed from said solution by evaporation through heat. Vacuum distillation may be desirable in this process. The thermoplastic resin recovered as described above is used as is for molding material, or after crushing or pelletizing.

The resultant molding material is desirably molded as is to be a new resin mold from the point of recycling, but if necessary, virgin resin material may be mixed in with said molding material, or a recycle aid agent as described later, is mixed in with said molding material to improve impact resistance of said molding material before said molding material is manufactured into said resin mold.

The solvent recovered in said resin recovering process is reusable as solvent, and metal, inorganic filler, and the like, once removed as insoluble elements, are recovered as much as possible, and recycled.

### [Recycle aid agent]

Said recycle aid agent used in the present invention is e.g. a virgin thermoplastic resin of the same kind as the thermoplastic resin of said resin mold, or virgin thermoplastic resin having compatibility with the thermoplastic resin of said resin mold or rubber like material. Said virgin thermoplastic resin and said rubber like material may be used together as recycle aid agents.

Said rubber like material is a graft rubber wherein the backbone part is diene group rubber, olefin group rubber or acrylic rubber and the branch part is a graft chain having compatibility with the thermoplastic resin of said resin mold so that said rubber like materials as said recycle aid agents used in the present invention are diene group rubber graft polymer, olefin group rubber graft polymer, and acrylic rubber graft polymer. Graft copolymers of olefin group rubber and graft copolymer of acrylic rubber are preferable graft copolymers as said recycle aid agents since said graft copolymers have respectably good heat stabilities.

Each rubber like material is illustrated below.

### A: Olefin group rubber graft-polymer

Said olefin group rubber used in said equal quality recycle aid agent of the present invention is polymer or copolymer of one or more kind(s) of an α -olefin or copolymer of one or more kind(s) of said α -olefin and one or more kind (s) of other monomer(s) which can be copolymerized with said *α*-olefin(s). Typically, said olefin group rubber may be copolymer of ethylene and one or more kind(s) of other α -olefin(s) or copolymer of ethylene and one or more kind(s) of other α -olefin(s) and other monomer(s) which can be copolymerized with said α -olefin, especially said other monomer is non-conjugated diene compound.

In said ethylene-α-olefin group copolymer, *α*-olefin which is copolymerized with ethylene may be α -olefin having 3 to 12 carbon atoms such as propylene, butene-1, 4-methyl pentene-1, hexane-1, octene-1, and the like.

Said non-conjugated diene compound may be e.g. dicyclopentadiene, tricyclopentadiene, 5-methyl-2,5-norbomadiene, 5-methylene-2-norbornene, 5-vinyl-2-norbornene, 5-ethylidene-2-norbornene, 5-isopropylidene-2-norbornene, 5-isopropenyl-2-norbornene, 5-(1-butenyl)-2-norbornene, 5-(2-propenyl)-2-norbornene, 5-(5-hexenyl)-2-norbomene, 4,7,8,9-tetrahydro-indene, isopropylidenetetrahydro-indene, cyclooctadiene, vinylcyclohexene, 1,5,9-cyclododecatoluene, 6-methyl-4,7,8,9-tetrahydroindene, 2,2'-dicyclopentenyl, trans-1,2-divinylcyclobutane, 1,4-hexadiene, 2-methyl-1, 4-hexadien, 1,6-actadien, 1,7-octadien, 1,8-nonadiene, 1,9-decadiene, 3,6-dimethyl-1,7-octadiene, 4,5-dinethyl-1,7-octadiene, 1,4,7-octatriene, 5-methyl-1,8-nonadiene and the like.

Preferably said non-conjugated diene compound may be 5-ethylilidine-2-norbomen(ENB) and/or dicyclopentadiene (DCP), more preferably dicyclopentadiene. An mixture of an olefin group rubber graft polymer containing 5-ethylidene-2-norbornen and an AS or a PS gives a resin mold having a good appearance.

Further, in the case of said olefin group rubber graft polymer containing EPDM, impact strength of the resulting resin mold may be greater than in the case of said olefin group rubber graft polymer containing EPM.

The molar ratio of ethylene-α-olefin and a non-conjugated diene compound, if necessary, in said olefin group rubber graft polymer ethylene/α-olefin/non-conjugated diene compound is preferably 0.2~1.0/0.2~0.8/0~0.2 and more preferably 0.5~ 0.9/0.25~0.75/0~0.1 and molar ratio of ethylene/propylene is 60/40 and more, preferably 65/35 and more and from a standpoint of recyclability of mechanical properties (impact resistance and the like) of the resulting resin mold, ethylene-propylene copolymer rubber(EPM) or ethylene-propylene-non conjugated diene compound terpolymer (EPDM) in which ethylene is richly contained is preferably used.

Further, the mooney viscosity (ML_{1+4,} 100 °C) of said ethylene- α -olefin group copolymer is preferably 5 to 150, more preferably 10 to 120, the optimum viscosity is 20 to 80 over and from a stand point of recyclability.

Typical olefin group rubber may be ethylene-propylene copolymer rubber (EPM), ethylene-propylene-non-conjugated diene compound terpolymer (EPDM), ethylene-butene copolymer rubber (EBM), ethylene-butene-non- conjugated diene compound terpolymer(EBDM). The same non- conjugated diene compound as used in EPDM may be used in EBDM.

To give compatibility with the objective thermoplastic resin with respect to said olefin group rubber, styrene group monomer and/or nitrile group monomer is (are) graft-copolymerized to said olefin group rubber.

Said styrene group monomer being graft-copolymerized to said olefin group rubber may be e.g. one or more kinds of styrene monomers comprising styrene, α-alkylmonovinylidene aromatic monomer (e.g. α-methylstyrene, α-ethylstyrene, α-methylvinyltoluene, α-methyldialkylstyrene and the like), cyclo-substituted alkylstyrene (e.g. *o, m,* or *p*-vinyltoluene, *o*-ethylstyrene, *p*-ethylstyrene, 2,4-dimethylstyrene, p-*tert* butylstyrene and the like), cyclo-substituted halo styrene (e.g. *o*-chlorostyrene, *p*-chlorostyrene, *o*-bromostyrene, 2,4-dichlorostyrene and the like), cyclo-alkyl, cyclo halo substituted styrene (e.g. 2-chloro-4-methylstyrene, 2,6-dichlorostyrene and the like), vinyl naphthalene, vinyl anthracene and the like.

In general, alkyl group having 1 to 4 carbon atom(s) includes both linear chain and branched chain.

Said nitrile group monomer being graft-copolymerized to said olefin group rubber may be e.g. acrylonitrile, methacrylonitrile, ethacrylonitrile, fumaronitrile, a mixture of two or more kinds of said nitrile, and the like.

Besides said styrene group monomer and said nitrile group monomer, other monomers (third monomer) may be copolymerized. Any kind of monomer which can be copolymerized with said styrene group monomer and nitrile group monomer may be used for copolymerization and generally said third monomer may be e.g. (meth)acrylates such as methyl(meth)acrylate, ethyl(meth)acrylate and the like, maleimides such as N-phenylmaleimide, maleimide, N-methylmaleimide, N-ethylmaleimide, (p-bromophenyl) maleimidemethacrylate, cyclohexylmaleimide and the like, unsaturated nitrile compounds such as maleic anhydride methacrylonitrile and the like.

Alkyl ester having 1 to 4 carbon atoms, especially methacrylate is preferable as (meth)acrylate.

To graft-polymerize said monomer(s) to said olefin rubber, polymerization system in which said monomer(s) is(are) polymerized by oil soluble or water soluble initiator and/or high energy ray such as ultraviolet ray, electron beam, and the like in the presence of said olefin group rubber is applied. In said polymerization system, general polymerization method such as bulk polymerization, suspension polymerization, solution polymerization, emulsion polymerization and the like is applied.

Said graft olefin group rubber produced by said graft polymerization includes both graft polymer in the narrow sense consisting of olefin group rubber as a backbone and a polymer chain of said monomer(s) as a branch and mixture of said graft polymer in the narrow sense and olefin group rubber and/or polymer of said monomer(s).

Said olefin group rubber graft polymer used as said recycle aid agent and suitable for each of said thermoplastic resin is described below.

### (1) Graft polymer for styrene group resin

One or more kind(s) of styrene or styrene analog monomer(s) graft polymerized olefin group rubber (styrene graft olefin group graft polymer) is used for the styrene group resin especially PS or HIPS. Said styrene graft olefin group graft polymer has the polymer branch chain of said styrene group monomer having substantially the same solubility parameter as said styrene group resin, especially PS, so that said styrene graft olefin group graft polymer has good compatibility with PS.

For styrene group resin, especially AS or ABS, olefin group rubber graft polymer wherein one or more kind(s) of styrene and/or other styrene group monomer(s) and one or more kind(s) of acrylonitrile and/or other nitrile group monomer(s) are graft polymerized to said olefin group rubber (styrene-nitrile graft olefin graft polymer) is used as said recycle agent.

Other monomer(s) which can be copolymerized with said styrene group monomer(s) and said nitrile group monomer(s) may be copolymerized with said styrene group monomer(s) and said nitrile group monomer(s).

Said styrene-nitrile graft olefin group graft polymer has the styrene-nitrile copolymer branch chain having substantially the same solubility parameter as AS or ABS, so that said styrene-nitrile graft olefin group graft polymer has a good compatibility with AS or ABS.

In said olefin group rubber graft polymer, said olefin group rubber may used singly or a mixture of two or ore olefin group rubbers may be used as said olefin group rubber. In said olefin group rubber graft polymer, the content of said olefin group rubber is generally 10 to 80% by weight, preferably 15 to 75% by weight, the content of monomer(s) grafted (graft ratio) is generally 90 to 20% by weight, preferably 55 to 25% by weight, and in the case of styrene-nitrile graft olefin group rubber graft polymer, the content of styrene group monomer is preferably 5 to 95% by weight and the content of nitrile group monomer is preferably 95 to 5% by weight. In the range described above, improvement effect on the compatibility of said olefin group rubber graft polymer with said thermoplastic resin, on the recyclability of said thermoplastic resin, in other words, degradation preventing effect on impact strength of said thermoplastic resin can be balanced when said thermoplastic resin is recycled.

Since said olefin group graft polymer is mixed into said thermoplastic resin on a moleculer level, the size of said olefin group graft polymer particles is desirably less than 5.0 µ m, more desirably in the range of 0.001 to 2.0 µ m. In this particle size range, the improvement effect on the recyclability of said olefin group rubber graft polymer may be especially remarkable.

In a case where two or more identical or different kinds of said olefin group rubber having respective different particle sizes are used in combination, the amount of olefin group rubber graft polymer added to thermoplastic resin can be reduced, as said thermoplastic resin's physical properties are improved.

Further, the reduced viscosity of toluene soluble component of said olefin group rubber graft polymer η sp/c (0.5g/dl toluene solution at 30 °C) is preferably in the range of 0.30 to 1.00g/dl, and more preferably in the range of 0.50 to 0.80g/dl.

Concretely, said olefin group rubber graft polymer may be styrene graft EPM and / or EPDM (St-g-EPM, St-g-EPDM, St-g-EPM-EPDM) in which styrene is graft-polymerized with EPM and/or EPDM in the case of using for PS or HIPS, acrylonitrile-styrene graft EPM and/or EPDM (AnSt-g-EPM, AnSt-g-EPDM, AnSt-g-EPM-EPDM) in which acrylonitrile and styrene are graft-polymerized with EPM and/or EPDM in the case of using for AS or ABS, styrene graft EBM and / or EBDM (St-g-EBM, St-g-EBDM, St-g-EBM-EBDM) in which styrene is graft-polymerized with ethylene-butene rubber (EBM) and/or ethylene-butene-diene terpolymer (EBDM) in the case of using for PS, acrylonitrile-styrene graft EBM and/or EBDM (AnSt-g-EBM, AnSt-g-EBDM, AnSt-g-EBM-EBDM) in which acrylonitrile and styrene are graft-polymerized with EBM and/or EBDM in the case of using for AS or ABS.

In this invention, AS and AnSt-g-EPM mixed resin is described as EPM-AS, AS and AnSt-g-EPDM mixed resin is described as EPDM-AS, AS, AnSt-g-EPM and AnSt-g-EPDM mixed resin is described as EPM-EPDM-AS, PS and St-g-EPM mixed resin is described as EPM-PS, PS and St-g-EPDM mixed resin is described as EPDM-PS, and, PS, St-g-EPM and St-g-EPDM mixed resin is described as EPM-EPDM-PS.

Further, mixed resin of graft rubber wherein nitrile monomer such as acrylonitrile and styrene group monomer are graft copolymerized to said acrylic rubber and AS is described as acryl-AS and mixed resin of styrene group monomer grafted acrylic rubber and AS is also described as acryl-PS.

### (2) Graft polymer for PPE group resin

PPE consists of a structure unit having phenyl group as described above, so that styrene graft olefin group rubber graft polymer such as St-g-EPM, St-g-EPDM , St-g-EPM-EPDM, St-g-EBM St-g-EBDM, St-g-EBM-EBDM and the like are preferably selected. Said olefin group rubber graft polymer has styrene polymer side chain having similar solubility parameter to PPE so that said olefin group rubber graft polymer has good compatibility with PPE group resin and said olefin group rubber graft polymer is mixed stably in said PPE group resin without separation to improve the recyclability of said PPE group resin.

In this invention, PPE and St-g-EPM (which is olefin type rubber graft polymer) mixed resin is described as EPM-PPE, PPE and St-g-EPDM mixed resin is described EPDM-PPE, PPE, St-g-EPM and St-g-EPDM mixed resin is described as EPM-EPDM-PPE, PS and EPM-PPE mixed resin is described as EPM-PS-PPE, PS and EPDM-PPE mixed resin is described as EPDM-PS-PPE, and, PS, St-g-EPDM and St-g-EPDM mixed resin is described EPM-EPDM-PS-PPE.

Further, mixed resin of PPE and acrylic rubber graft polymer, St-g-acrylic rubber is described as acryl-PPE, mixed resin of PS and acryl-PPE is also described as acryl-PS-PPE.

### B: Acrylic rubber graft polymer

Said acrylic rubber used in the present invention may be e.g. acrylate homopolymer having alkyl group having 2 to 8 carbon atoms preferably, such as ethylacrylate, n-butylacrylate, 2-ethylhexylacrylate and the like, copolymer comprising two kinds and more of acrylate monomers mentioned above, copolymer comprising one or more kinds of acrylate monomer(s) mentioned above and butadiene or one or more kinds of other monomer(s) such as non-conjugated diene compounds which can be used for EPDM similarly, acrylonitrile, methylmethacrylate, vinyl acetate, styrene, ethylene, propylene and the like, copolymer comprising one or more kinds of acrylate monomer(s) and functional monomer(s) such as acrylic acid methacrylic acid, β-hydroxyethylmethacrylate, acrylamide, dimethylaminoethylmethacrylate and the like, or polymerization silane coupling agent(s) such as γ-methacryloxypropyltrimethoxysilane, vinyltriacetoxysilane, *p*-trimethoxysilylstyrene, *p*-triethoxysilylstyrene, *p*-trimethoxysilyl, α-methylstyrene, *p*-triethoxysilyl-α-methylstyrene, γ-acryloxypropyltrimethoxysilane, vinyltrimethoxysilane, N-β(N-vinylbenzylaminoethyl-γ-aminopropyl) trimethoxysilane hydrochloride and the like.

As acrylic rubber for common use, copolymers, copolymerized with above mentioned functional monomer, such as polyethyl acrylate, poly n-butyl acrylate, n-butyl acrylate-acrylonitrile copolymer, n-butylacrylate-butadiene copolymer, n-butyl acrylate-ethylene copolymer, n-butyl acrylate-γ-methacryloxypropyltrimethoxysilane copolymer, n-butylacrylate-vinyltrimethoxysilane copolymer and the like may be used in this invention.

n-Butyl acrylate-butadiene copolymer having a mole ratio of n-butylacrylate/butadiene 30/70 and more is preferable to acrylic rubber.

Said acrylic rubber may be produced by suspension polymerization, emulsion polymerization, and the like.

Styrene group monomer(s) or styrene group monomer(s) and nitrile group monomer(s) are graft polymerized to said acrylic rubber to give said acrylic rubber compatibility with styrene group resin, PPE group resin and PC group resin the same as with said olefin group rubber. To balance compatibility and degradation preventive effectiveness of impact strength in recycling, the content of said acrylic rubber may be preferably 10 to 80% by weight, more preferably 15 to 75% by weight and the content of said grafted monomer(s) (graft ratio) may be preferably 90~20% by weight, more preferably 55 to 25% by weight in all. In the case of styrene-nitrile graft acrylic rubber graft polymer, the content of styrene group monomer(s) may be preferably 5 to 95% by weight and the content of nitrile group monomer(s) may be preferably 95 to 5% by weight.

In above described range, compatibility of said acrylic rubber graft polymer with said thermoplastic resin and recyclability of said thermoplastic resin, in other words, degradation preventive effectiveness of impact strength balance respectively.

In the present invention, if desired, an inorganic reinforcement such as a calcium carbonate, magnesium carbonate, barium sulfate, calcium sulfate, calcium sulfite, calcium phosphate, calcium hydroxide, magnesium hydroxide, aluminum hydroxide, magnesium oxide, titanium oxide, iron oxide, zinc oxide, alumina, silica, diatomite, gypsum, talc, clay, asbestos, mica, glass fiber, carbon fiber, calcium silicate, bentonite, white carbon, carbon black, iron powder, aluminum powder, powdered feldspar, slag, fly ash, cement, zirconia powder, and the like, an organic reinforcement such as a polyamide fiber, Kevlar fiber, aramid fiber, polyester fiber, acryl fiber, viscose fiber, acetate fiber, paper, and the like may be used as a recycle aid agent. Said reinforcing material may be used singly or two or more kinds of said reinforcing materials may be used together.

The present invention is illustrated by following EXAMPLES, however said EXAMPLES do not limit the scope of the present invention.

### [EXAMPLE 1]

### ( Molding)

ABS resin (soluble thermoplastic resin element) containing 40% by weight of glass fiber (insoluble element) and a styrene modified PPE (soluble thermoplastic resin element) containing 40 % by weight of glass fiber and a fire retardant containing phosphorus were used as mold materials. Both kinds of said mold materials were injection-molded, respectively, using an injection molding machine, its clamping pressure set to be 100 tons to manufacture printed circuit board (Print Wire Board PWB) base molds.

In said injection molding, to prevent separation of the glass fiber in each resin, the temperature of said mold surface was set to be higher than each resin's glass transition temperature(Tg) using a high frequency induction heating apparatus.

Besides heating by high frequency induction, heating by a halogen lamp, heating by steam, heating by heater, oil, and the like can be applied to heat the inside of the mold. Further, a polycarbonate (soluble thermoplastic resin element) containing 40% by weight of glass fiber (insoluble element) was used as a mold material and said mold material was molded using the same method as described above to manufacture a PWB base mold.

The three kinds of PWB base molds, manufactured as described above, exhibited no glass fiber separation on visual inspection, demonstrating that plating and coating layer's adhesive strength suffers no deterioration as a result of said glass fiber separation.

### [Circuit forming]

Three kinds of said PWB base molds were treated respectively with a mixed solution. consisting of a mixture of chromic acid anhydride, potassium dichromate and sulfuric acid for etching, then washed with water, after which a their catalyst was attached to each respective PWB base mold.

Next, each respective PWB base mold was first coated with a chemical copper plating, then an electric copper plating to form a thin copper film on the surface of each respective PWB base mold.

An ultraviolet curing type paint containing an epoxy acrylate resin as main component was then coated on the surface of said thin copper film of said PWB base mold by pad printing, after which said coating film was treated with irradiated ultraviolet rays, curing said coating film of said ultraviolet curing type paint, making it an insoluble element. The uncured part(s) of said coating film was(were) removed with solvent after which said PWB base mold was nitric acid treated by etching, the remaining part(s) of said coating film to form a circuit.

### (Manufacture of PWB)

An epoxy resin paint(insoluble element) was coated on the surface of each PWB on which said circuit was formed, to protect said thin copper film of said circuit.

Further, letters and the like were printed on said epoxy resin paint's coating film with a printing ink containing epoxy resin as its main component, and a ┌Repelle┘ symbol was printed on the surface of each PWB, to indicate recyclability. IC(s), resistance(s), and the like were assembled into each PWB.

### (Soldering)

Said IC(s), resistance(s), and the like were assembled into each PWB and each is treated by flowing for three seconds in a solder A consisting of Sn-58 Bi (which has a melting point of about 140°C), a solder B consisting of Sn-37Pb(with a melting point about 180°C), and a solder C consisting of Sn-3.0 Ag-0.5Cu (with melting point of about 220°C), each being soldered to the copper plated circuit part during the PWB's assembly (PWBA).

### (Recycling of PWBA)

As described above, there were three respective kinds of PWB base mold; these consisted of ABS, a modified PPE, and polycarbonate, each respective PWB containing 40% by weight of glass fiber, with thin copper film circuits formed on the surface of each respective PWB, further, IC(s), resistances, and the like were added to said circuit, to complete the Print Board Assembly(PWBA).

To recycle said discarded PWBA, said PWBA was dipped in a MEK/chloroform(50/50) solvent mixture or a toluene solvent without removing the IC(s), resistance(s), and the like assembled into said PWB, and without crushing said PWBA, and if necessary said PWBA having been dipped in said solvent was heated at about 60°C to dissolve said soluble thermoplastic resin element. The resulting solution of said discarded PWBA was separated using a centrifugal separator, and then filtered to remove the insoluble elements such as Cu thin film, ink film, and the like from said PWBA after which said solvent(s) of said solution of said thermoplastic resin was(were) distilled to recover said thermoplastic resin.

The recovered thermoplastic resin lumps (ABS, styrene modified PPE, or PC) were crushed respectively, and 40% by weight of glass fiber was mixed in each said recovered crushed thermoplastic resin. Then 400 parts by weight of virgin ABS or styrene modified PPE or PC, each of which contains 40% by weight of glass fiber, were mixed into 100 parts by weight of each mixture of said recovered crushed thermoplastic resin and glass fiber, and the resulting mixtures were respectively pelletized to prepare the mold material for recycled printed circuit board.

### (Remold)

Using said recycled mold materials, recycled printed circuit board A was manufactured by injection molding in the same way as described above.

The Izod impact strength (kg · cm/cm) of each of the recycled printed circuit board A was measured by the method following ASTM-D256. To compare with Izod impact strength of said recycled printed circuit board A, printed circuit board X(s), made of virgin ABS containing 40% by weight of glass fiber, virgin modified PPE containing 40% by weight of glass fiber, and virgin PC containing 40% by weight of 40% glass fiber, were manufactured by injection molding, and the Izod impact strength of each printed circuit board X was also measured. The results are shown in Table 1.

**Table 1**

| Izod impact strength | | |
|---|---|---|
| Resin | Printed circuit board A | Printed circuit board X |
| ABS | 6.5 | 6.4 |
| Modified PPE | 5.8 | 5.4 |
| PC | 21.5 | 20.0 |

The ratio of impact of impact strength(%) deterioration =(the Izod impact strength of board A)/ (the Izod impact strength of board X) × 100, was calculated for each resin, and calculated deterioration ratios of the Izod impact strengths(%) were 101%, 107%, and 107% respectively, confirming that each board A has enough mechanical strength for printed circuit board.

### [EXAMPLE 2]

A discarded ABS resin mold which was a cabinet (front cover) of a printer was crushed wherein a paint consisting of nickel powder and carbon powder(acetylene black/carbon black) as conductive materials and styrene modified acrylic resin having compatibility with ABS resin as vehicle was coated on the surface of said resin mold to form a conductive coating film.

Said crushed resin mold was dissolved in methyl ethyl ketone to recover ABS resin as in EXAMPLE 1.

The Izod impact strength (kg · cm/cm) of said recovered recycled ABS resin was measured by the method following ASTM-D256 method in the same manner as in EXAMPLE 1. Further, virgin ABS resin was molded and the heat experience effect on the resulting mold was given, to provide the same condition for heat degradation as said recycled resin, to the resin of said resin mold, and a sample for comparison was prepared. The Izod impact strength of said sample was also measured. The results are shown in Table 2.

**Table 2**

| EXAMPLE | Recycled ABS resin | Virgin ABS resin |
|---|---|---|
| 2 | 16.8 | 16.7 |

The deterioration ratio of the Izod impact strength=(the Izod impact strength of recycled resin)/ (the Izod impact strength of virgin resin) × 100, was calculated the result being 100%, confirming that said recycled resin contained no insoluble contaminants, and was useful as the resin material for e.g. a printer cabinet.

### [EXAMPLE 3]

A discarded resin mold was crushed as it is wherein thin nickel film was formed on the surface of an ABS resin base mold to shield it from electromagnetic wave using a chemical nickel plating, and a thermosetting acryl modified urethane resin paint was coated on said thin nickel film for decoration, and further, logotype mark was printed on said paint coated layer using a two component ink containing a thermosetting epoxy resin as its main component. Said crushed resin mold was then dissolved in a solvent mixture of methyl ethyl ketone/toluene(60/40 weight ratio), and an insoluble element such as said thin nickel film and the like, and a soluble thermoplastic resin element, were then separated with a centrifugal separator. The resulting resin solution was then evaporated as in EXAMPLE 1 to recover the ABS lumps. It was confirmed that said ABS lumps contained no insoluble elements such as plating film, coating film, ink film and the like.

Said ABS lumps were crushed and 5 parts by weight of recycle aid agent which was a graft rubbery polymer having compatibility with ABS was added to said crushed ABS lumps to restore physical properties, wherein said graft rubbery polymer was an acrylonitrile-styrene graft EPDM, third components of said EPDM were DCP(molar ratio of E/P/DCP=65/25/10 and Mooney viscosity ML₁₊₄ was 80 at 100°C, average particle size was about 1µm, An/EPDM/st=about 23/29/48, and graft ratio was 71% by weight), and thus recycled mold material was prepared. The Izod impact strength (kg · cm/cm) was measured by the method following ASTM-D256 and the result is shown in Table 3.

**Table 3**

| EXAMPLE | Recycled ABS resin | Virgin ABS resin |
|---|---|---|
| 3 | 23.1 | 16.7 |

### [EXAMPLE 4]

The electric nickel plating was coated on the surface of an ABS resin mold using said recycled mold material of EXAMPLE 3, and said plated resin mold was crushed and dissolved in the same manner as the former EXAMPLES to separate insoluble element and soluble element, and the resulting solution was evaporated to recover the resin, after which said resin was crushed and pelletized to prepare recycled material. The mechanical properties of said recycled material were almost the same as those of the recycled material of EXAMPLE 3. Further, it was confirmed that said recycled material contained no plating film as an insoluble element. The Izod impact strength (kg · cm/cm) of said recycled material was measured by the method following ASTM-D256 and the result is shown in Table 4.

**Table 4**

| EXAMPLE | Recycled ABS resin | Virgin ABS resin |
|---|---|---|
| 4 | 16.5 | 16.7 |

### [COMPARISON]

The PWBA on the market was respectively dipped in MEK and then toluene, and kept for 48 hours at 30°C, wherein said PWBA has a base board made of epoxy resin containing glass fiber, and IC and resistances are attached by soldering and then solubilities of base board, sealing agent of IC, printing ink, resist film and the like were estimated.

The results of FT-IR of MEK and toluene in which said PWBA were respectively dipped and virgin MEK and virgin toluene were compared.

As a result, it was confirmed that the MEK and toluene in which said PWBA were respectively dipped contained no exuding material.

Considering the results described above, it was expected that the recycling of the resin of said base board becomes possible by replacing solvent insoluble thermosetting resin with solvent soluble thermoplastic resin.

Further, it was confirmed following an energy dispersive X-ray spectroscopy (EDX) method, that the resulting solutions contained no inorganic material such as metal.

### Industrial Utility

The thermoplastic resin contained in a discarded compound resin mold such as a printed circuit board and the like can be dissolved in solvent, so that a high temperature does not adversely affect said thermoplastic resin during recovering, preventing the degradation of said thermoplastic resin. Further, by using the recycling method of the present invention, insoluble elements such as thin metal film, such as Cu thin film, Ni thin film and the like, thermosetting resin coating film, glass fiber, and inorganic filler can be easily removed.

## Claims

1. A compound resin mold consisting of thermoplastic resin element(s) being solvent soluble and having a heat distortion point higher than 80°C, said point being measured by the method following ASTM D648, applying a load of 1,820 MPa, and solvent insoluble element(s)

2. A compound resin mold in accordance with claim 1, wherein said compound resin mold is a printed circuit board, said board being made of said thermoplastic resin element, being solvent soluble, and said solvent insoluble elements being thin metal film circuit and thermosetting resin film formed on said board

3. A compound resin mold in accordance with claims 1 or 2, wherein a fire retardant containing no halogen element is added to said solvent soluble thermoplastic resin element

4. A compound resin mold in accordance with claims 1 to 3, wherein a fire retardant containing phosphorus and/or metal hydroxide is added to said solvent soluble thermoplastic resin element

5. A method for manufacturing a recycled compound resin mold comprising dissolving discarded compound resin molds of claims 1 to 4 in solvent to separate insoluble element(s), recovering said thermoplastic resin element(s) dissolved in said solvent by evaporating said solvent and recycling said recovered thermoplastic resin as usable resin mold material

6. A method for manufacturing a recycled compound resin mold in accordance with claim 5, wherein recycle aid agent(s) is (are) added to said recycled thermoplastic resin recovered by evaporating said solvent in which said thermoplastic resin is dissolved

7. A method for manufacturing a recycled compound resin mold in accordance with claim 6, wherein said recycle aid agent(s) is(are) virgin thermoplastic resin and/or virgin thermoplastic resin having compatibility with said recycled thermoplastic resin and/or rubber-like material and/or inorganic reinforcing material and/or organic reinforcing material
